# EUROPÄISCHE PATENTSCHRIFT

(11) **EP 1 656 719 B1**
(45) Veröffentlichungstag und Bekanntmachung des Hinweises auf die Patenterteilung: **06.04.2011**
(21) Anmeldenummer: 03818255.6
(22) Anmeldetag: 22.08.2003
(51) Int. Cl.: H01R 13/33, H01R 13/24, H01L 23/48

(54) **DRUCKKONTAKTFEDER FÜR KONTAKTANORDNUNG IN LEISTUNGSHALBLEITERMODUL**
PRESSURE CONTACT SPRING FOR A CONTACT ARRANGEMENT IN A POWER SEMICONDUCTOR MODULE
RESSORT DE CONTACT A PRESSION POUR CONFIGURATION DE CONTACT DANS UN MODULE A SEMI-CONDUCTEUR DE PUISSANCE

(43) Veröffentlichungstag der Anmeldung: 17.05.2006
(73) Patentinhaber: ABB Schweiz AG, 5400 Baden (CH)
(72) Erfinder: HERR, Egon, CH-8050 Zürich (CH); ASSAL, Jérôme, CH-8004 Zürich (CH)
(74) Vertreter: ABB Patent Attorneys
(86) Internationale Anmeldenummer: PCT/CH2003/000569
(87) Internationale Veröffentlichungsnummer: WO 2005/020383

(56) Entgegenhaltungen:
- DE-B- 1 276 158
- US-A- 4 012 094
- US-A- 4 623 207
- US-B1- 6 246 247
- US-B1- 6 579 804
- PATENT ABSTRACTS OF JAPAN vol. 010, no. 347 (E-457), 21. November 1986 (1986-11-21) & JP 61 150249 A (TOSHIBA CORP), 8. Juli 1986 (1986-07-08)

## Beschreibung

### Technisches Gebiet

Die Erfindung bezieht sich auf das Gebiet der Leitungselektronik, insbesondere auf das Gebiet der Leistungshalbleitermodule.

Die Erfindung betrifft eine elektrische Druckkontaktfeder gemäss dem Oberbegriff des Patentanspruchs 1, eine elektrische Kontaktanordnung sowie ein Leistungshalbleitermodul.

### Stand der Technik

In heutigen Leistungshalbleitermodulen werden üblicherweise Bonddrähte zur Kontaktierung von Halbleiter-Steuerelektroden, beispielsweise Gate-Elektroden von Insulated Gate Bipolar Transistor (IGBT) verwendet. Die Bonddrähte werden dabei üblicherweise mit Ultraschall auf die Metallisierung der Halbleiter geschweisst.

Zum Schutz vor Staub und Feuchtigkeit und um die Elektroden der Leistungshalbleiter sauber zu isolieren werden Halbleiter und Bonddraht typischerweise in ein weiches, elektrisch isolierendes Silikon-Gel eingebettet.

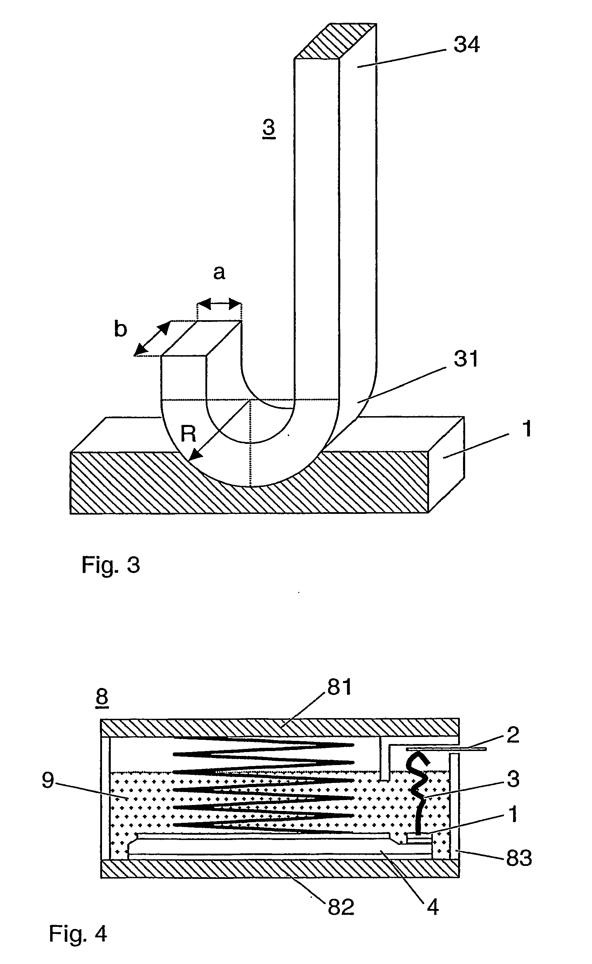

In C.Göbl et al, "SkiiP 3", SEMIKRON Elektronik GmbH, (www.semikron.com/jahr2000/pcimskiip3.pdf) ist ein solches System offenbart. Fig. 4 zeigt ein Halbleitermodul mit einem Halbleiterchip, welcher über einen Bonddraht kontaktiert ist. Der Bonddraht ist auf dem Substrat befestigt und über eine Kontaktfeder mit dem Steuerschaltung verbunden.

Eine alternative Technologie, die jedoch nur in hermetischen Gehäusen ohne Silikon-Gel angewandt wird, ist die Kontaktierung der Steuerelektroden mittels einer Druckkontaktfeder. Dabei wird ein Kontaktstift mit einer kegel- bzw. zylinderförmige Feder auf die Steuerelektrode gepresst. Die Feder übt eine geringe Federkraft von beispielsweise 1 N aus. Aufgrund der geringen Federkraft wird der Kontaktstift nur wenig in die Metallisierung der Elektrode eindringen, gerade ausreichend, um einen sicheren Kontakt zwischen Kontaktstift und Steuerelektrode zu gewährleisten.

Bei der Anwendung von solchen Federstiften in mit Silikon-Gel gefüllten Modulen ergibt sich das Problem, dass entweder die Federn mit dem zähflüssigen Gel verstopft und so in der Bewegung gehindert werden, oder dass der Kontaktstift aufgrund des zähflüssigen Gels unter gewissen Betriebsbedingungen keinen zuverlässigen Kontakt zur Steuerelektrode herstellen kann.

Um die Kontaktsicherheit zu verbessern kann beispielsweise die Federkraft erhöht oder die Spitze des Kontaktstifts zugespitzt werden. Dadurch dringt der Kontaktstift tiefer in die Metallisierung der Elektroden ein und wird auch bei kräftigeren mechanischen Einwirkungen des Gels auf die Kontaktfeder für eine ausreichende Verbindung sorgen. Allerdings besteht bei erhöhter Federkraft die Gefahr, dass der spitzige Kontaktstift die Metallisierung durchdringt und die Elektrode darunter beschädigt.

### Kurze Darstellung der Erfindung

Die Aufgabe der Erfindung besteht folglich darin, eine elektrische Druckkontaktfeder der eingangs genannten Art zu schaffen, mit welcher unter allen Betriebsbedingungen eine verbesserte Kontaktierung gewährleistet ist.

Diese Aufgabe wird mit einer elektrischen Druckkontaktfeder mit den Merkmalen des unabhängigen Anspruchs 1 gelöst.

Die erfindungsgemässe Druckkontaktfeder umfasst zwei Kontaktierungsbereiche zum Kontaktieren von elektrisch leitfähigen Kontaktstellen, wobei einer der beiden Kontaktierungsbereiche eine Kontaktspitze umfasst. Zwischen den Kontaktierungsbereichen ist ein Komprimierbereich mit mindestens einer Drahtkrümmung angeordnet. Ein in der Kontaktspitze mündender und aus dem Komprimierbereich hervorgehender, gerader Drahtabschnitt verläuft in Richtung der Federkraft. Die Kontaktspitze der erfindungsgemässen Druckkontaktfeder ist abgerundet mit einem Aussenradius, wobei der Aussenradius der ein- bis dreifachen Drahtdicke entspricht.

Über den gerade ausgebildeten Drahtabschnitt zwischen Komprimierbereich und Kontaktspitze wird die Kontaktspitze der erfindungsgemässen Druckkontaktfeder mit der ganzen, in der Drahtrichtung wirkenden Federkraft gegen die Kontaktstelle gedrückt. Die abgerundete Kontaktspitze dringt selbst bei hoher Federkraft nur wenig in die Metallisierung der Kontaktstelle ein.

Die abgerundete Kontaktspitze lässt sich durch Biegen des Drahts im Kontaktierungsbereich auf einfache Weise realisieren. Dadurch muss die Kontaktspitze nicht aufwendig bearbeitet und präzise geschliffen werden.

In einer Ausführungsform weist die erfindungsgemässe Druckkontaktfeder einen rechteckigen Querschnitt mit einer Dicke und einer Tiefe auf. Die Druckkontaktfeder ist ausschliesslich in einer Ebene senkrecht zur Tiefe gebogen. Dadurch wird erreicht, dass sich die Druckfeder beim Zusammendrücken lediglich in dieser einen Ebene biegt.

Die erfindungsgemässe Druckkontaktfeder wird in einer Ausführungsform in einer elektrischen Kontaktanordnung eingesetzt. Sie dient als elektrisch leitfähige Verbindung zwischen zwei einander gegenüberliegend angeordneten, elektrisch leitfähigen Kontaktstellen der Kontaktanordnung.

Die Kontaktstelle sind derart ausgebildet, dass sie ein zu tiefes Eindringen der Kontaktspitze verhindern. Beispielsweise weisen sie eine Härte von 45 bis 70 Hv auf, bei einer erfindungsgemässen Druckkontaktfeder mit einer entsprechend abgerundeten Kontaktspitze und einer Federkraft zwischen 4 und 12 N.

Um bei erhöhtem Federdruck ein zu tiefes Eindringen der Kontaktspitze der Druckkontaktfeder in die eine Kontaktstelle der Kontaktanordnung zu verhindert, weist die elektrisch leitfähige Kontaktstelle eine Barrierenschicht auf, welche unterhalb einer Oberflächenschicht angeordnet ist, und welche aus einem gegenüber dem Material dieser Oberflächenschicht härteren Material besteht. Die Oberflächenschicht kann daher ein sehr weiches Material enthalten, welches eine sichere Verbindung zur Kontaktspitze der Druckkontaktfeder garantiert.

Die Barrierenschicht weist vorzugsweise Aussparungen auf, welche mit dem weicheren, elektrisch leitfähigen Material der Oberflächenschicht ausgefüllt sind.

Die Kontaktanordnung mit der erfindungsgemässen Druckkontaktfeder wird in einer Ausführungsform in einem Leistungshalbleitermodul eingesetzt. Dabei ist eine Elektrodenmetallisierung eines Leistungshalbleiterchips die von der Kontaktspitze kontaktierte Kontaktstelle der Kontaktanordnung. Die zweite Kontaktstelle ist ein aus dem Modul geführter Anschluss.

Das Leistungshalbleitermodul mit der Kontaktanordnung mit der erfindungsgemässen Druckkontaktfeder ist mit einem elektrisch isolierenden Gel gefüllt. Dank der erfindungsgemässen Druckkontaktfeder ist ein sicherer Kontakt zwischen dem aus dem Modul geführten Anschluss und der Elektrode des Leistungshalbleiterchips gewährleistet. Die Druckfeder kann mit einer erhöhten Federkraft beaufschlagt werden, ohne dass die Kontaktspitze der Druckkontaktfeder die Metallisierung der Leistungshalbleiterelektrode durchdringt.

### Kurze Beschreibung der Zeichnungen

Bevorzugte Ausführungsformen der Erfindung werden anschliessend anhand von Zeichnungen erläutert. Dabei zeigt:
- Fig. 1: eine schematische Darstellung einer Kontaktanordnung mit einer erfindungsgemässen Druckkontaktfeder,
- Fig. 2: die Kontaktanordnung nach Fig.1, mit einer ersten Ausführungsform der erfindungsgemässen Druckkontaktfeder,
- Fig. 3: die Kontaktanordnung nach Fig.1, mit einer zweiten Ausführungsform der erfindungsgemässen Druckkontaktfeder, und
- Fig. 4: eine schematische Darstellung eines Leistungshalbleitermoduls mit der Kontaktanordnung nach Fig. 1.

### Weg zur Ausführung der Erfindung

In den Figuren sind gleichwirkende Teile mit gleichen Bezugszeichen versehen.

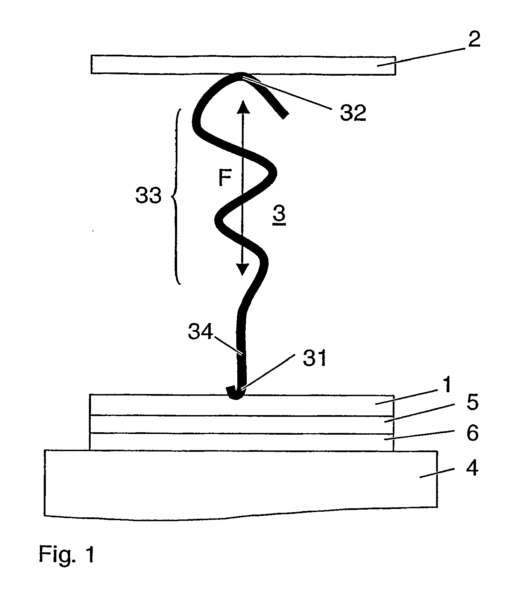

Fig. 1 zeigt schematisch eine Kontaktanordnung eines Leistungshalbleitermoduls mit der erfindungsgemässen Druckkontaktfeder 3. Die Druckkontaktfeder ist als elektrisch leitfähige Verbindung zwischen zwei einander gegenüberliegend angeordneten, elektrisch leitfähigen Kontaktstellen 1 und 2 eingespannt. Die Kontaktstelle 1 ist die Metallisierung einer Steuerelektrode des Leistungshalbleiters. Die schematisch dargestellte Elektrode 5 ist durch eine Isolierschicht 6 vom Leistungshalbleiter 4 getrennt. Bei der Kontaktstelle 2 handelt es sich um einen aus dem Modul geführten Steueranschluss welcher beispielsweise eine Leiterplatte (Printed Circuit Board) umfasst, welche an der Innenseite eines Gehäusedeckels des Moduls angeordnet ist.

Die erfindungsgemässe Druckkontaktfeder ist aus einem 0.2-0.6 mm dicken, elektrisch leitfähigen Draht hergestellt, beispielsweise einem Metalldraht aus Kupfer oder einer Kupfer- und Berylliumverbindung. Der Draht wird zu einer Feder geformt und gegebenenfalls thermisch ausgehärtet. Anschliessend wird die Feder trowallisiert um die Kanten abzurunden bevor in einem letzten Arbeitsschritt eine Beschichtung aufgetragen wird. Die Beschichtung muss elektrisch gut leitend sein und darf nicht bei Luftkontakt oxidieren bzw. bei Kontakt mit Metalloberflächen korrodieren oder chemisch reagieren. Typischerweise wird die Feder mit einem Edelmetall beschichtet, beispielsweise mit Gold. Die Druckkontaktfeder weist in unkomprimiertem Zustand eine Länge zwischen 5 und 15 mm auf.

Die erfindungsgemässe Druckkontaktfeder umfasst zwei Kontaktierungsbereiche 31 und 32 zum Kontaktieren der Kontaktstellen 1 und 2 der Kontaktanordnung. Zwischen den beiden Kontaktierungsbereichen befindet sich ein komprimierbarer Federbereich 33, welcher mindestens eine Drahtbiegung umfasst. Der erste Kontaktierungsbereich 31 ist zu einer Spitze geformt, während in der dargestellten Ausführungsform der zweite Kontaktierungsbereich 32 aus einer Drahtbiegung besteht.

Zwischen dem Komprimierbereich 33 und der Kontaktspitze 31 ist die Druckkontaktfeder als ein gerades Drahtstück 34 ausgebildet, welches in Richtung der vom Komprimierbereich ausgeübten Federkraft F verläuft.

Die Kontaktspitze, welche an einem Ende des geraden Drahtstücks 34 angeordnet ist, wird durch die Federkraft F senkrecht gegen die Kontaktstelle 1 gedrückt. Dadurch ergibt sich ein definierter Kontaktpunkt, welcher sich dank dem grossen lokalen Druck nicht so leicht auf der Kontaktstelle verschieben lässt.

Die Drahtbiegung des zweiten Kontaktierungsbereichs 32 hat im Kontaktpunkt eine grössere Auflagefläche und somit einen geringeren relativen Anpressdruck. Die Drahtbiegung liegt nicht mit einem fest definierten Punkt an der zweiten Kontaktstelle 2 an, sondern ist bewegbar, je nachdem, wie stark die Druckkontaktfeder durch mechanischen und/ oder thermischen Druck zusammengedrückt wird. Wird die Druckkontaktfeder in einer Kontaktanordnung verwendet, in der nur in den Bereich der ersten Kontaktstelle ein Gel eingebracht ist, kann der zweite Kontaktierungsbereich wie in der dargestellten Ausführungsform als Drahtbiegung ausgebildet sein. Sollte die ganze Kontaktanordnung und insbesondere die Bereiche beider Kontaktstellen mit Gel gefüllt sein, kann auch der zweite Kontaktierungsbereich mit einer Kontaktspitze versehen sein, um auch im Bereich der zweiten Kontaktstelle einen sauberen Kontakt zu gewährleisten.

In einem Druckkontakt ergibt sich die Kontaktfläche A_{b} der beiden Kontaktelemente aus A_{b} = F / Hᵥ, wobei F die Kontaktkraft und Hᵥ die Härte des weicheren Kontaktelementes ist.

In der beschriebenen Kontaktanordnung bestimmt folglich die Form der Kontaktspitze 31 der Druckkontaktfeder 3 zusammen mit der Federkraft F und der Härte Hᵥ der Oberfläche der Kontaktstelle 1 die Eindringtiefe der Kontaktspitze in die Metallisierung 11 der Kontaktstelle. Um bei gegebener Federkraft und Härte der Metallisierung 11 eine gewünschte maximale Eindringtiefe zu erzielen, ist die Kontaktspitze 31 abgerundet mit einem Aussenradius welcher im eigentlichen Kontaktbereich zwischen Kontaktspitze 31 und Metallisierung 11 der ein- bis dreifachen Drahtdicke der Druckkontaktfeder entspricht.

Beim Kontaktieren der Kontaktstelle durch die Kontaktspitze ist die Kontaktfläche zuerst klein, was ein Eindringen der Kontaktspitze in die Kontaktstelle ermöglicht. Sobald die Kontaktspitze ein wenig in die Kontaktstelle eingedrungen ist, vergrössert sich die Kontaktfläche. Die mit zunehmender Eindringtiefe rasch ansteigende Kontaktfläche sorgt für zunehmenden mechanischen Kontaktwiderstand. Anders als bei herkömmlichen, zugespitzten Kontaktspitzen nimmt die Kontaktfläche und der entsprechende mechanische Kontaktwiderstand schon bei sehr geringer Eindringtiefe sehr schnell zu. Durch die Wahl eines entsprechenden Radius der Rundung der Kontaktspitze kann bei gegebener Federkraft, Härte und Dicke der Metallisierung die gewünschte maximale Eindringtiefe auf beispielsweise die halbe Dicke der Metallisierung festgelegt werden.

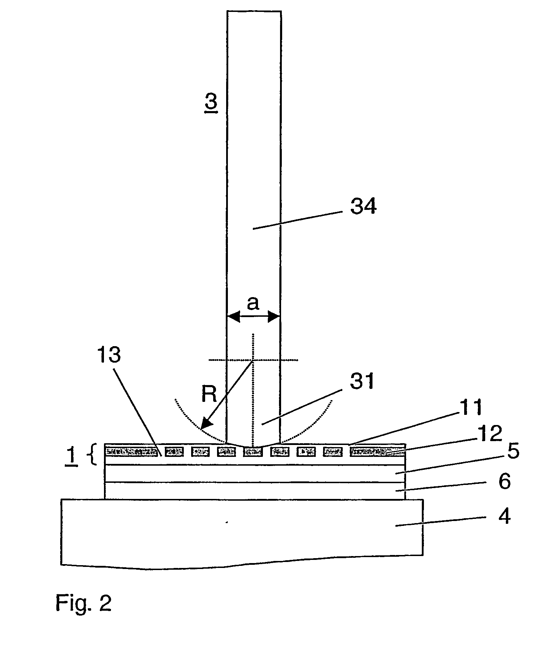

Fig. 2 zeigt eine erste Ausführungsform der Kontaktspitze 31 der erfindungsgemässen Druckkontaktfeder. Das gerade Drahtstück 34 endet in einer abgerundeten Spitze 31. Die Kontaktspitze hat einen Aussenradius R welcher rund zweimal grösser ist als die Dicke a des Drahtes.

Die Abrundung kann zylindrisch, d.h. symmetrisch bezüglich einer Senkrechten zur Drahtrichtung, oder kugelförmig, d.h. kreissymmetrisch bezüglich dem Mittelpunkt der Kontaktspitze sein.

Um die maximale Eindringtiefe zusätzlich zu begrenzen ist in der in Fig. 2 dargestellten Ausführungsform der Kontaktanordnung in der Metallisierung der Kontaktstelle 11 eine Barrierenschicht 12 vorgesehen. Die Barrierenschicht ist unterhalb der Oberfläche der Metallisierung angebracht. Sie besteht aus einem Material, welches härter ist als das Material der Metallisierung im Bereich der Oberfläche, beispielsweise Siliziumnitrid. Die Barrierenschicht kann auch aus einem harten elektrisch leitfähigen Material bestehen. Die Metallisierung 11 der Kontaktstelle umschliesst die Barrierenschicht 12. Die Oberflächenschicht dient der Kontaktierung durch die Druckkontaktfeder, während eine unterhalb der Barrierenschicht angeordnete Metallschicht beispielsweise der Kontaktierung einer darunterliegenden Polysilizium-Elektrode dient. Um eine optimale elektrische Verbindung dieser beiden Metallisierungsschichten zu gewährleisten sind in der Barrierenschicht Aussparungen vorgesehen welche mit dem Material der Metallisierungsschichten ausgefüllt sind.

Fig. 3 zeigt eine weitere Ausführungsform der Kontaktspitze 31 der erfindungsgemässen Druckkontaktfeder 3. Die Kontaktspitze ist ebenfalls abgerundet und weist einen Aussenradius von der rund 2.5-fachen Drahtdicke auf. Die Rundung ist jedoch durch eine kleine Drahtbiegung am Ende des geraden Drahtstücks 34 geformt. Diese Kontaktspitze lässt sich ohne aufwendige Schneid- und Schleifvorgänge einfach durch Biegen des Drahtes mit dem gewünschten Radius formen. Da der Aussenradius der Drahtbiegung in der Grössenordnung von einem halben Millimeter ist, wirkt die Federkraft im eigentlichen Kontaktpunkt im wesentlichen in der Richtung des geraden Drahtstücks 34.

Der für die Druckfeder verwendete Draht kann einen runden oder wie in der Fig. 3 dargestellt einen rechteckigen Querschnitt mit der Dicke a und der Tiefe b haben. Typische Werte sind etwa a=0.3 mm und b=0.6 mm. Die Druckkontaktfeder ist in einer Ebene senkrecht zur Tiefe des Drahtes gebogen. Dies stabilisiert die Feder und sorgt für den gewünschten Druck in die Richtung senkrecht zur Ebene der Kontaktstelle 1. Ein insbesondere im Komprimierbereich 33 dreidimensional gebogenes, beispielsweise spiralförmiges Drahtstück würde durch Silikon-Gel, welcher in den Zwischenraum zwischen Halbleiterchip und dem Gehäusedeckel eingebracht wird, in der Bewegungsfreiheit stärker beeinträchtigt. Das zweidimensional gebogene Drahtstück ist daher die bevorzugte Ausführungsform.

Fig. 4 zeigt schematisch das Leistungshalbleitermodul 8 mit der Kontaktstelle mit der erfindungsgemässen Druckkontaktfeder 3. Das Modul umfasst ein Gehäuse 83 sowie elektrisch leitfähige Deckel- und Bodenplatten 81 und 82, welche als Leistungsanschlüsse für den Leistungshalbleiter 4 dienen. Die Druckkontaktfeder 3 ist im Bereich der Steuerelektrode des Leistungshalbleiters angeordnet, zwischen der Metallisierung 1 der Steuerelektrode und einem aus dem Modul geführten Steueranschluss 2. Das Modul ist im Bereich des Leistungshalbleiters, insbesondere im Bereich der obenliegenden Leistungselektrode und der Steuerelektrode mit einem elektrisch isolierenden Silikon-Gel gefüllt. Dadurch sind Leistungs- und Steuerelektrode elektrisch sauber isoliert.

### Bezugszeichenliste

- 1: Erste Kontaktstelle, Elektrodenmetallisierung
- 11: Oberflächenschicht
- 12: Barrierenschicht
- 13: Aussparungen
- 2: Zweite Kontaktstelle
- 3: Druckkontaktfeder
- 31 , 32: Kontaktierungsbereich
- 33: Komprimierungsbereich
- 34: Gerades Drahtstück
- 4: Leistungshalbleiterchip
- 5: Steuerelektrode
- 6: Isolationsschicht
- 8: Leistungshalbleitermodul
- 81, 82: Leistungsanschlüsse
- 83: Modulgehäuse

## Patentansprüche

1. Elektrische Druckkontaktfeder (3) aus elektrisch leitfähigem Draht, mit
- einem ersten Kontaktierungsbereich (31) zum Kontaktieren einer ersten elektrisch leitfähigen Kontaktstelle (1) eines Leistungshalbleiterchips, wobei im ersten Kontaktierungsbereich zum Kontaktieren der Kontaktstelle eine abgerundete Kontaktspitze (31) angeordnet ist und
- die Kontaktspitze (31) einen Aussenradius (R) aufweist, welcher der ein- bis dreifachen Dicke des Drahtes (a) entspricht,
- einem zweiten Kontaktierungsbereich (32) zum Kontaktieren einer zweiten elektrisch leitfähigen Kontaktstelle (2), und
- einem zwischen dem ersten Kontaktierungsbereich (31) und dem zweiten Kontaktierungsbereich (32) angeordneten Komprimierbereich (33) mit mindestens einer Drahtkrümmung,
wobei ein in der Kontaktspitze (31) mündender und aus dem Komprimierbereich (33) hervorgehender, gerader Drahtabschnitt (34) in Richtung der Federkraft (F) verläuft,
**dadurch gekennzeichnet, dass**
- der Draht im ersten Kontaktierungsbereich gebogen ist, und dass
- dieser Drahtbogen die Kontaktspitze (31) formt.

2. Druckkontaktfeder gemäss Anspruch 1, **dadurch gekennzeichnet, dass**
- der Draht einen rechteckigen Querschnitt aufweist mit einer Dicke (a) und einer Tiefe (b), und dass
- die Feder in einer Ebene senkrecht zur Tiefe (b) gebogen ist.

3. Elektrische Kontaktanordnung, umfassend
- eine erste elektrisch leitfähige Kontaktstelle (1) eines Leistungshalbleiterchips,
- eine zweite elektrisch leitfähige Kontaktstelle (2), sowie
- eine elektrisch leitfähige Verbindung (3) zwischen der ersten und der zweiten Kontaktstelle,
wobei die beiden Kontaktstellen einander gegenüberliegend angeordnet sind und die Verbindung eine zwischen den beiden Kontaktstellen geklemmte, elektrische Druckkontaktfeder (3) gemäss einem der Ansprüche 1 bis 2 ist.

4. Kontaktanordnung gemäss Anspruch 3, **dadurch gekennzeichnet, dass**
- die erste Kontaktstelle (1) eine Härte von 45 bis 70 Hv aufweist, und dass die Federkraft (F) zwischen 4 und 12 N liegt.

5. Kontaktanordnung gemäss Anspruch 3, **dadurch gekennzeichnet, dass**
- die Kontaktanordnung Mittel umfasst, mit welchen Mitteln die Kontaktspitze (31) der Druckkontaktfeder beim Eindringen in die erste Kontaktstelle (1) am Durchdringen der ersten Kontaktstelle gehindert wird.

6. Kontaktanordnung gemäss Anspruch 5, **dadurch gekennzeichnet, dass**
- die Mittel eine mehrschichtige erste Kontaktstelle (1) umfassen, wobei unter einer Oberflächenschicht (11) eine Barrierenschicht (12) angeordnet ist, welche aus einem gegenüber dem Material der Oberflächenschicht (12) härteren Material besteht.

7. Kontaktanordnung gemäss Anspruch 6, **dadurch gekennzeichnet, dass**
- die Barrierenschicht (12) Aussparungen (13) aufweist, welche Aussparungen mit dem Material der Oberflächenschicht (11) ausgefüllt sind.

8. Leistungshalbleitermodul (8), umfassend
- mindestens ein Leistungshalbleiterchip (4) mit mindestens einer Elektrode mit einer Metallisierung (2), sowie
- mindestens eine elektrische Kontaktanordnung gemäss einem der Ansprüche 4 bis 7,
wobei die Elektrodenmetallisierung (2) die erste Kontaktstelle der Kontaktanordnung und ein aus dem Modul geführter Anschluss (1) die zweite Kontaktstelle der Kontaktanordnung ist.

9. Leistungshalbleitermodul gemäss Anspruch 8, **dadurch gekennzeichnet, dass**
d as Leistungshalbleitermodul (8) im Bereich zwischen der ersten und der zweiten Kontaktstelle mit einem elektrisch isolierenden Gel (9) gefüllt ist.

## Claims

1. Electrical pressure contact spring (3) of electrically conductive wire, with
- a first contacting region (31) for contacting a first electrically conductive contact pad (1) of a power semiconductor chip,
a rounded contact tip (31) being arranged in the first contacting region for contacting the contact pad, and
- the contact tip (31) having an outer radius (R), which corresponds to one to three times the thickness of the wire (a),
- a second contacting region (32) for contacting a second electrically conductive contact pad (2), and
- a compressing region (33), with at least one wire curvature, arranged between the first contacting region (31) and the second contacting region (32),
a straight piece of wire (34) extending from the compressing region (33) and finishing in the contact tip (31) running in the direction of the spring force (F),
**characterized in that**
- the wire is bent in the first contacting region, and **in that**
- this wire bend forms the contact tip (31).

2. Pressure contact spring according to Claim 1, **characterized in that**
- the wire has a rectangular cross section with a thickness (a) and a depth (b), and **in that**
- the spring is bent in a plane perpendicular to the depth (b).

3. Electrical contact arrangement, comprising
- a first electrically conductive contact pad (1) of a power semiconductor chip,
- a second electrically conductive contact pad (2), and
- an electrically conductive connection (3) between the first and second contact pads,
the two contact pads being arranged opposite each other and the connection being an electrical contact spring (3) clamped between the two contact pads according to either of Claims 1 and 2.

4. Contact arrangement according to Claim 3, **characterized in that**
- the first contact pad (1) has a hardness of from 45 to 70 Hv, and **in that** the spring force (F) lies between 4 and 12 N.

5. Contact arrangement according to Claim 3, **characterized in that**
- the contact arrangement comprises means by which the contact tip (31) of the pressure contact spring is prevented from penetrating through the first contact pad (1) when it penetrates into said first contact pad.

6. Contact arrangement according to Claim 5, **characterized in that**
- the means comprise a multilayered first contact pad (1), a barrier layer (12) which consists of a harder material than the material of a surface layer (12) being arranged under said surface layer (11).

7. Contact arrangement according to Claim 6, **characterized in that**
- the barrier layer (12) has clearances (13) which are filled with the material of the surface layer (11).

8. Power semiconductor module (8), comprising
- at least one power semiconductor chip (4) with at least one electrode with a metallization (2), and
- at least one electrical contact arrangement according to one of Claims 4 to 7,
the electrode metallization (2) being the first contact pad of the contact arrangement and a terminal (1) led out from the module being the second contact pad of the contact arrangement.

9. Power semiconductor module according to Claim 8, **characterized in that**
the power semiconductor module (8) is filled with an electrically insulating gel (9) in the region between the first and second contact pads.

## Revendications

1. Ressort de contact de pression (3) électrique à base de fil électroconducteur, comprenant :
- une première zone de mise en contact (31) pour la mise en contact avec un premier point de contact (1) électroconducteur d'une puce à semi-conducteurs de puissance, une pointe de contact (31) arrondie étant disposée dans la première zone de mise en contact pour la mise en contact avec le point de contact et
- la pointe de contact (31) présentant un rayon extérieur (R) qui correspond à une à trois fois l'épaisseur du fil (a),
- une seconde zone de mise en contact (32) pour la mise en contact avec un second point de contact (2) électroconducteur, et
- une zone de compression (33) disposée entre la première zone de mise en contact (31) et la seconde zone de mise en contact (32) avec au moins une courbure de fil,
une partie de fil (34) droite, débouchant dans la pointe de contact (31) et dépassant de la zone de compression (33), étant agencée en direction de la force de ressort (F),
**caractérisé en ce que**,
- le fil est plié dans la première zone de mise en contact, et **en ce que**
- cet arc de fil forme la pointe de contact (31).

2. Ressort de contact selon la revendication 1, **caractérisé en ce que**
- le fil présente une section transversale rectangulaire avec une épaisseur (a) et une profondeur (b), et **en ce que**
- le ressort est plié dans un plan perpendiculairement à la profondeur (b).

3. Agencement de contact électrique, comprenant
- un premier point de contact (1) électroconducteur d'une puce à semi-conducteurs de puissance,
- un second point de contact (2) électroconducteur, et
- une liaison (3) électroconductrice entre le premier et le second point de contact,
les deux points de contact étant disposés l'un en face de l'autre et la liaison étant un ressort de contact de pression (3) électrique, coincé entre les deux points de contact, selon l'une quelconque des revendications 1 à 2.

4. Agencement de contact selon la revendication 3, **caractérisé en ce que**
- le premier point de contact (1) présente une dureté allant de 45 à 70 Hv, et **en ce que** la force de ressort (F) se situe entre 4 et 12 N.

5. Agencement de contact selon la revendication 3, **caractérisé en ce que**
- l'agencement de contact comprend des moyens avec lesquels la pointe de contact (31) du ressort de contact de pression est empêchée de pénétrer dans le premier point de contact (1) lors de l'enfoncement dans le premier point de contact.

6. Agencement de contact selon la revendication 5, **caractérisé en ce que**
- les moyens comportent un premier point de contact (1) multicouche, une couche de barrière (12) qui est à base d'un matériau plus dur par rapport au matériau de la couche de surface (12), étant disposée sous une couche de surface (11).

7. Agencement de contact selon la revendication 6, **caractérisé en ce que**
- la couche de barrière (12) présente des évidements (13) qui sont remplis avec le matériau de la couche de surface (11).

8. Module à semi-conducteurs de puissance (8), comprenant
- au moins une puce à semi-conducteurs de puissance (4) comprenant au moins une électrode avec une métallisation (2), et
- au moins un agencement de contact électrique selon l'une quelconque des revendications 4 à 7,
la métallisation des électrodes (2) étant le premier point de contact de l'agencement de contact et un branchement (1) guidé à la sortie du module étant le second point de contact de l'agencement de contact.

9. Module à semi-conducteurs de puissance selon la revendication 8, **caractérisé en ce que**
- le module à semi-conducteurs de puissance (8) est rempli avec un gel (9) isolant électriquement dans la zone comprise entre le premier et le second point de contact.
